# EUROPEAN PATENT APPLICATION

(11) **EP 1 976 354 A1**
(43) Date of publication of application: **01.10.2008**
(21) Application number: 06712032.9
(22) Date of filing: 20.01.2006
(51) Int. Cl.: H05K 3/32, H01L 33/00

(54) **CHIP COMPONENT MOUNTING STRUCTURE, CHIP COMPONENT MOUNTING METHOD AND ELECTRONIC DEVICE**

(71) Applicant: FUJITSU LIMITED, Kawasaki-shi, Kanagawa 211-8588 (JP)
(72) Inventor: YOKOZAWA, Hiroshi, Kawasaki-shi Kanagawa 211-8588 (JP)
(74) Representative: Kreutzer, Ulrich
(86) International application number: PCT/JP2006/300807
(87) International publication number: WO 2007/083378

(57) **Abstract**

A chip component mounting structure and a chip component mounting method are disclosed that are adapted to increase the chip component mounting density. In the chip component mounting structure, an LED is surface-mounted on a signal electrode and a common ground electrode formed on a substrate. The areas of the signal electrode and the common ground electrode are different, and the LED is bonded to the signal electrode and the common ground electrode using a conductive adhesive (21).

## Description

### TECHNICAL FIELD

The present invention relates to a chip component mounting structure, a chip component mounting method, and an electronic device that are adapted to increase the chip component mounting density.

### BACKGROUND ART

Conventionally, chip components such as resistor chips, condenser chips, and light emitting diodes (referred to as LEDs hereinafter) may be surface mounted on a substrate by being bonded to electrodes formed on the substrate using solder.

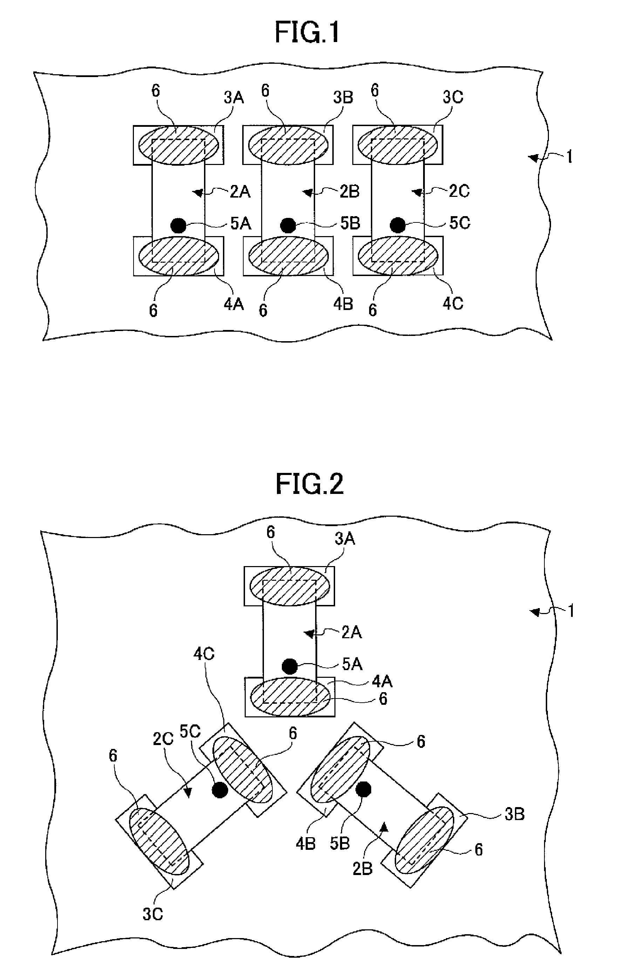

FIGS. 1-3 are diagrams showing examples of conventional chip component mounting structures. In these drawings, it is assumed that LEDs 2A-2C are used as chip components. In the example shown in FIG. 1, three LEDs 2A-2C are mounted close to each other in a parallel arrangement to increase the chip component mounting density.

In this example, signal electrodes 3A-3C and ground electrodes 4A-4C are arranged on a substrate 1 according to the shapes of the LEDs 2A-2C. Each of the LEDs 2A-2C has connection terminals arranged at its ends. The LEDs 2A-2C are mounted on the substrate 1 by bonding the connection terminals of the LEDs 2A-2C to the electrodes 3A-3C and 4A-4C using solder 6.

The LEDs 2A-2C each have light emitting portions 5A-5C. The LEDs 2A-2C are selectively arranged so that differing colors are emitted from their corresponding light emitting portions 5A-5C. In this way, at least three different colors may be generated by selectively lighting the LEDs 2A-2C.

It is noted that when the light emitting portions 5A-5C are spaced apart from each other, color irregularities may occur or a desired color may not be generated, for example. Accordingly, techniques are desired for mounting the LEDs 2A-2C at a high density and arranging the color emitting portions 5A-5C close to each other.

In this respect, the mounting structure of FIG. 1 has the LEDs 2A-2C arranged parallel so that the light emitting portions 5A-5C are also arranged parallel along one straight line. In this structure, the light emitting portion 5A at the left hand side of the drawing and the light emitting portion 5C at the right hand side of the drawing are separated by a relatively long distance so that color irregularities may be generated.

The mounting structure shown in FIG. 2 has the LEDs 2A-2C mounted in a radial arrangement so that the light emitting portions 5A-5C may be arranged close to each other. However, in the mounting structure shown in FIG. 2, the signal electrodes 3A-3C and the ground electrodes 4A-4C are each created individually for the LEDs 2A-2C, respectively. That is, in FIG. 2, even the ground electrodes 4A-4C that are arranged toward the center of the radial arrangement are created individually so that the light emitting portions 5A-5C cannot be arranged adequately close to each other.

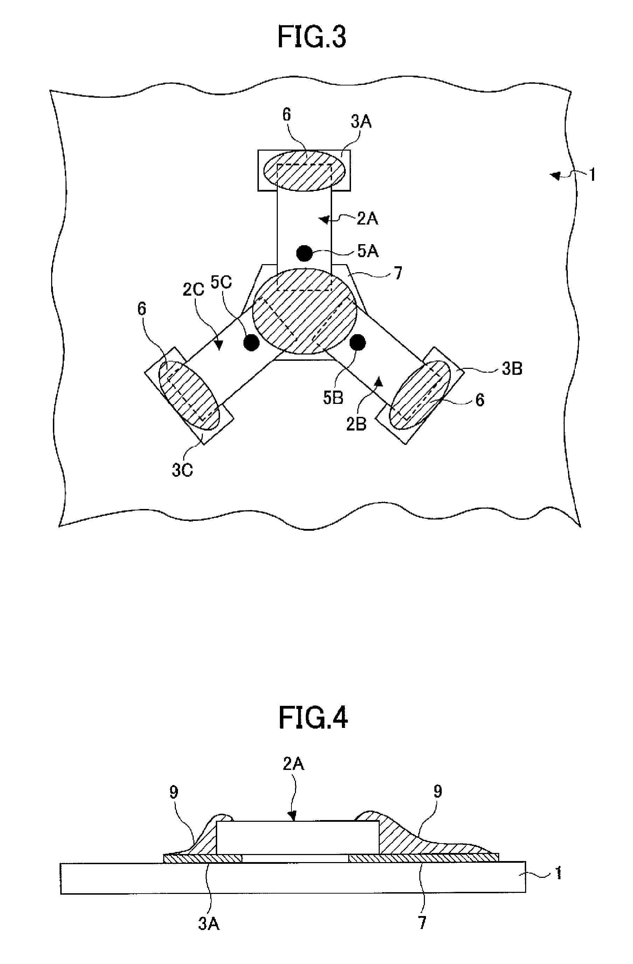

In this respect, the mounting structure as shown in FIG. 3 has been proposed which has the LEDs 2A-2C mounted in a radial arrangement and has the ground terminals 4A-4C integrated into a common ground terminal 7.

In another example, Japanese Laid-Open Patent Publication No. 10-290029 discloses a mounting structure in which plural LEDs are fixed to a substrate through die bonding and electrical connection between the substrate and the LEDs is established using wires. In such a mounting structure, the mounting positions of the LEDs are not restricted by the positions of bonding pads so that the LEDs may be arranged relatively close to each other.

However, in the mounting structure of FIG. 3, the so-called Manhattan phenomenon (chip standing phenomenon) may easily occur in the process of bonding the LEDs with solder 6. Such a phenomenon is described in detail below with reference to FIGS. 3, 4 and 5.

As is shown in FIG. 3, when the common ground terminal 7 to which the ground connection terminals of the LEDs 2A-2C are collectively bonded is formed to arrange the light emitting portions 5A-5C closer to each other, the area of the common ground electrode 7 becomes greater than the area of the signal ground electrodes 3A-3C. It is noted that the amount of solder used for bonding the electrodes may change approximately in proportion to the area of the electrodes. Accordingly, the amount of solder 6 used for bonding the common ground electrode 7 is greater than the amount of solder used for bonding the signal electrodes 3A-3C.

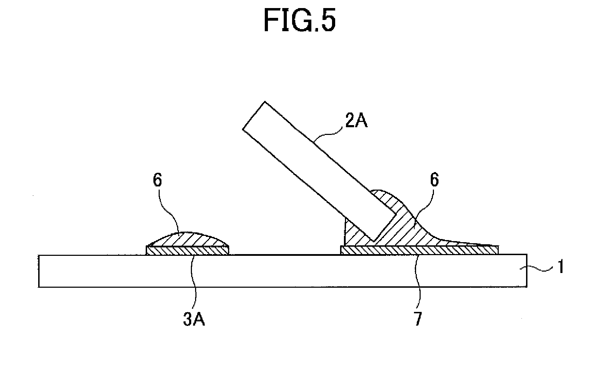

FIG. 4 is a diagram showing how the LED 2A (as a representative example of the LEDs 2A-2C) is provisionally attached to the signal electrode 3A and the common ground electrode 7 using cream solder 9. When a heating process is performed on the illustrated cream solder 9 to melt the cream solder 9 and remove organic components included therein, the so-called Manhattan phenomenon may occur in which the LED 2A detaches from the signal electrode 3A and stands up as is shown in FIG. 5.

The Manhattan phenomenon is believed to be caused by various factors, such as the surface tension created by molten solder 6 and the thermal expansion force of solder 6. It is known that such a phenomenon does not occur when the areas of the signal electrodes 3A-3C and the ground electrodes 4A-4C arranged at the two ends of the LEDs 2A-2C, respectively, are equivalent as in the examples shown in FIGS. 1 and 2. However, when the areas of the signal electrodes 3A-3C and the common ground electrode 7 are different as in the example of FIG. 3, the Manhattan phenomenon occurs in which the LED 2A detaches from the signal electrode 3A with the smaller area and stands on the common ground electrode 7 with the larger area.

As can be appreciated from the above descriptions, in the mounting structure shown in FIG. 3, although the light emitting portions 5A-5C may be arranged close to each other so that color irregularities may be prevented, mounting reliability may be degraded.

According to the disclosure of Japanese Laid-Open Patent Publication No. 10-290029, although the light emitting portions of the LEDs may be arranged close to each other, wires have to be used for bonding the LEDs, and additionally, a sealing process has to be performed to protect the wires. Thus, an electronic device using such a mounting structure may be enlarged.

### DISCLOSURE OF THE INVENTION

Aspects of the present invention are directed to providing an improved chip mounting structure, chip mounting method, and electronic device that solves one or more of the above-described problems.

More specifically, aspects of the present invention are directed to providing a chip mounting structure, a chip mounting method, and an electronic device that are adapted to increase the mounting density and prevent the occurrence of the Manhattan phenomenon.

According to one embodiment of the present invention, a chip component mounting structure is provided that includes a chip component that is surface mounted on a pair of electrodes formed on a substrate, wherein the electrodes of the pair of electrodes have differing areas, and the chip component and the electrodes are bonded using a conductive adhesive.

According to one aspect of the above embodiment, even when there is a difference in the areas of the electrodes to which the chip component is to be bonded, forces that may contribute to the occurrence of the Manhattan phenomenon, such as surface tension and thermal expansion force, are not generated in the conductive adhesive upon bonding the chip component. Thus, electrodes arranged on the substrate may be arbitrarily designed regardless of the areas of the electrodes and the electrodes to which the chip component is bonded may be suitably arranged for mounting the chip component at a high density.

In one preferred embodiment, plural chip components may be mounted on the substrate, and connection terminals of the chip components having identical properties may be connected to one common electrode that is formed on the substrate.

By implementing such a configuration, the chip components may be arranged close to each other.

In another preferred embodiment, plural chip components may be mounted on the substrate, connection terminals of the chip components having identical properties may be connected to one common electrode that is formed on the substrate, and the chip components may be radially arranged with respect to the common ground electrode.

In another preferred embodiment, the chip component may be a light emitting diode, plural light emitting diodes may be mounted on the substrate, connection terminals of the light emitting diodes having identical properties may be connected to one common electrode that is formed on the substrate, and the chip components may be radially arranged with respect to the common ground electrode.

In another preferred embodiment, the conductive adhesive may have a surface tension that is smaller than a surface tension of solder.

According to another embodiment of the present invention, an electronic device is provided that includes the substrate with the chip component mounting structure according to an embodiment of the present invention.

According to another embodiment of the present invention, a chip component mounting method is provided for surface mounting a chip component on a pair of electrodes formed on a substrate, the chip component mounting method including the steps of arranging a conductive adhesive on the pair of electrodes having differing areas, and connecting the chip component to the electrodes with the conductive adhesive.

According to one aspect of the above embodiment, because a conductive adhesive is used to connect the chip component to the electrodes, the bonding process may be performed under a lower temperature environment compared to the case of using solder so that the mounting process may be easily performed.

According to certain aspects of the above-described embodiments of the present invention, the Manhattan phenomenon may be prevented so that mounting reliability may improved, and the electrodes arranged on the substrate may be arbitrarily designed so that chip component mounting density may be increased.

### BRIEF DESCRIPTION OF THE DRAWINGS

FIG. 1 is a plan view of a first conventional example of a chip component mounting structure;
FIG. 2 is a plan view of a second conventional example of a chip component mounting structure;
FIG. 3 is a plan view of a third conventional example of a chip component mounting structure;
FIG. 4 is a diagram illustrating a problem occurring in the mounting structure shown in FIG. 3;
FIG. 5 is another diagram illustrating the problem occurring in the mounting structure shown in FIG. 3;

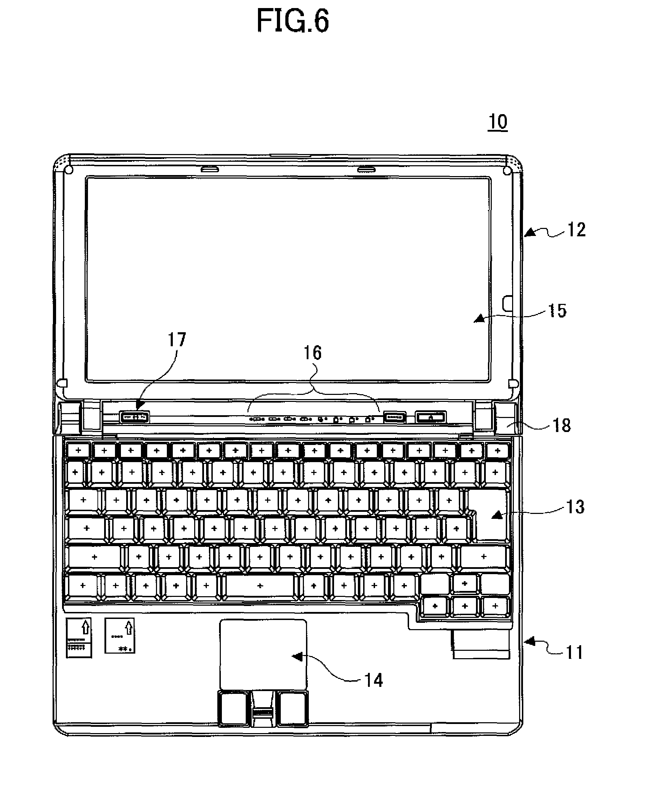

FIG. 6 is a diagram showing an electronic device that uses a chip component mounting structure according to an embodiment of the present invention;

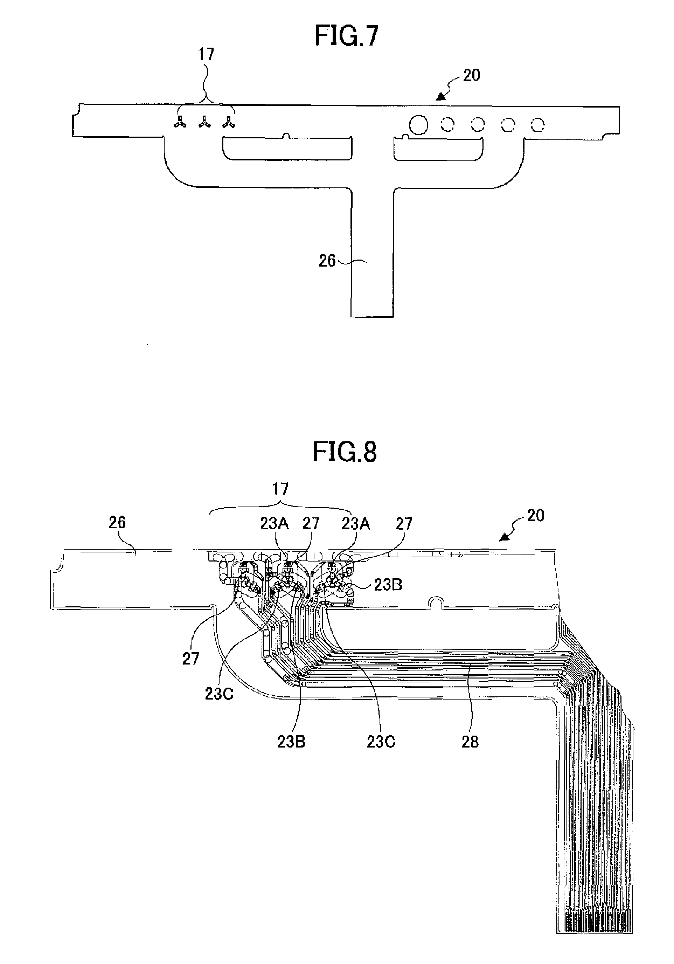

FIG. 7 is a plan view of a substrate including the chip component mounting structure according to the present embodiment;
FIG. 8 is an enlarged partial plan view of the substrate including the chip component mounting structure according to the present embodiment;

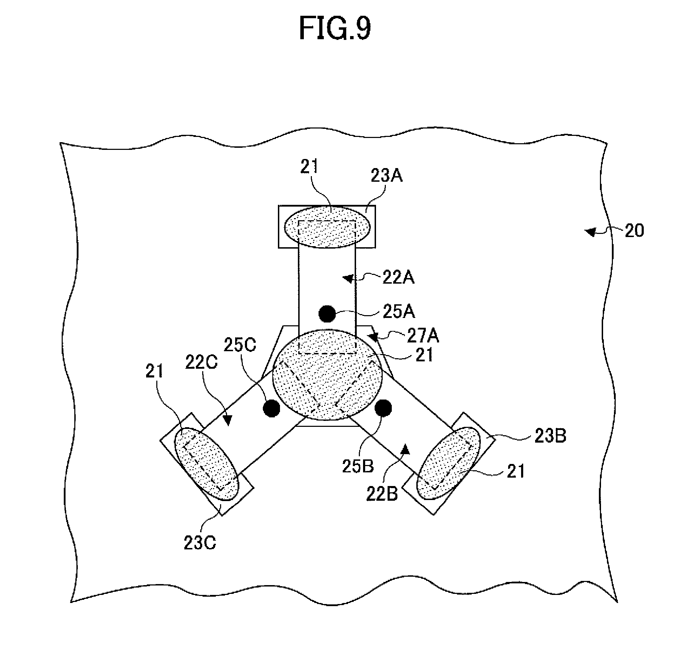

FIG. 9 is an enlarged view of the chip component mounting structure according to the present embodiment; and

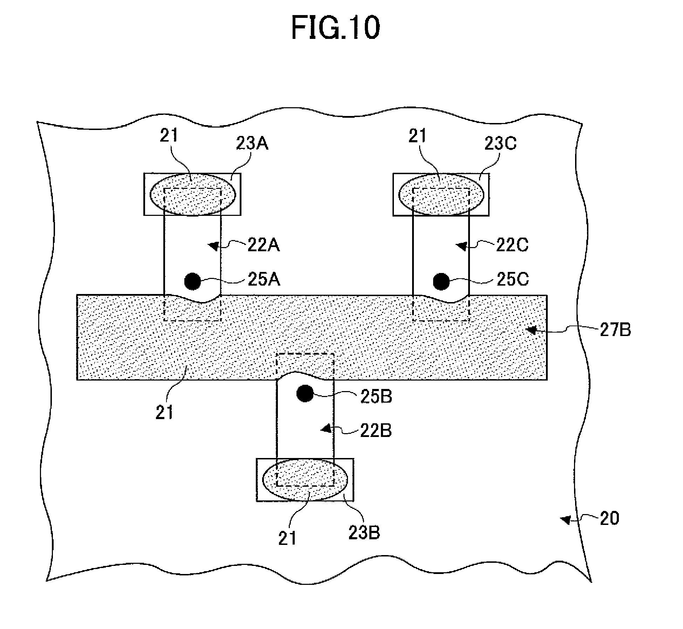

FIG. 10 is an enlarged view of a chip component mounting structure according to a modified example of the embodiment shown in FIG. 9.

### BEST MODE FOR CARRYING OUT THE INVENTION

In the following, preferred embodiments of the present invention are described with reference to the accompanying drawings.

FIG. 6 is a diagram showing an exemplary electronic device that uses a chip component mounting structure according to an embodiment of the present invention. It is noted that in this drawing, a personal computer 10 is illustrated as an exemplary electronic device using the chip component mounting structure according to the present embodiment. However, embodiments of the present invention may be applied to other various types of electronic devices as well. Also, it is noted that in the following descriptions, light emitting diodes (referred to as LEDs hereinafter) are illustrated as chip components. However, embodiments of the present invention may be applied to other types of chip components as well.

The illustrated personal computer 10 includes a main body part 11, a lid part 12, and a hinge part 18 that enables the lid part 12 to open and close with respect to the main body part 11.

The main body part 11 includes a keyboard 13 and a flat pointer 14, for example. The lid part 12 includes a liquid crystal display 15, for example. The hinge part 18 that is arranged between the main body part 11 and the lid part 12 includes a status indication unit 16 and a battery indication unit 17, for example.

The status indication unit 16 may include a power on/off status indication, a hard disk access indication, and a PC card access indication, for example. The battery indication unit 17 may include an indication of the remaining battery power status. It is noted that the mounting structure according to an embodiment of the present invention is applied to this battery indication unit 17. In the illustrated example, the battery indication unit 17 includes three indication units each having three LEDs 22A-22C (see FIG. 9) which are described below.

The three LEDs 22A-22C are selectively arranged to emit different colors. Accordingly, at least three different colors may be generated by selectively lighting the LEDs 22A-22C. For example, when adequate battery power is remaining, the LEDs 22A-22C in all of the three indication units may be arranged to emit yellow green light, and as the remaining battery power decreases, light emission of the three indications units may be adjusted to change from orange to red. In this way, the remaining battery power status may be accurately indicated to a user.

FIGS. 7 and 8 are diagrams showing a substrate 20 on which the LEDs 22A-22C are mounted. In the illustrated example, a flexible substrate is used as the substrate 20. The substrate 20 includes a substrate main body 26 that is fabricated from a flexible film made of resin (e.g., polyimide), a wiring pattern 28, signal electrodes 23A-23C, and a common ground electrode 27A, for example. The wiring pattern 28, the signal electrodes 23A-23C, and the common ground electrode 27A are created by forming predetermined patterns on copper using a printing technique and arranging a protective layer over the printed patterns.

The three indication units of the battery indication unit 17 each include the LEDs 22A-22C, the signal electrodes 23A-23C, and the common ground electrode 27A. FIG. 9 is an enlarged view of one of such indication units.

As is shown in FIG. 9, in the present example, the plural (i.e., three in the present example) LEDs 22A-22C are mounted in a radial arrangement so that their respective light emitting portions 25A-25C may be arranged close to each other. Also, one common ground electrode 27A is arranged to be connected to the ground side connection terminals of the LEDs 22A-22C. By using the common ground electrode 27, the light emitting portions 25A-25C of the LEDs 22A-22C may be arranged closer to each other so that the occurrence of color irregularities upon light emission may be prevented and desirable light emission may be achieved.

However, in the chip component mounting structure according to the present embodiment that includes the signal electrodes 23A-23C and the common ground electrode 27A as is described above, when the LEDs 22A-22C are bonded to the common ground electrode 27A using solder 6, the Manhattan phenomenon may occur due to the difference in the areas between the signal electrodes 23A-23C and the common ground electrode 27A.

Accordingly, in the present embodiment, conductive adhesive 21 is used for bonding the LEDs 22A-22C to the signal electrodes 23A-23C and the common ground electrode 27A. The conductive adhesive 21 may be made of resin such as epoxy that has conductive filler such as silver filler mixed therein, and the resin in the conductive adhesive 21 may be hardened so that the conductive adhesive 21 may function as a conductive member.

In the present embodiment, the LEDs 22A-22C may be bonded to the signal electrodes 23A-23C and the common ground electrode 27A by hardening the resin in the conductive adhesive 21. Specifically, electrical connection as well as a mechanical bond may be established between the LEDs 22A-22C and the signal electrodes 23A-23C and common ground electrode 27A. In other words, the conductive adhesive 21 may have functions similar to the solder 6 that is conventionally used to bond LEDs to corresponding connection electrodes.

However, unlike solder 6, the conductive adhesive 21 is created by mixing filler made of conductive metal into resin material. Therefore, the conductive adhesive 21 does not melt and surface tension is not generated even when it is heated. Also, the thermal expansion rate of the conductive adhesive 21 may be adjusted by adding other types of filler in addition to the conductive metal filler. In this way, the thermal expansion rate of the conductive adhesive 21 may be adjusted to a level that does not cause movement of the LEDs 22A-22C.

Thus, in the present embodiment, even when there is a difference in the areas between the signal electrodes 23A-23C and the common ground electrode 27A, the occurrence of the Manhattan phenomenon may be prevented in the process of bonding the LEDs 22A-22C to the signal electrodes 23A-23C and the common ground electrode 27A. In this way, the signal electrodes 23A-23C and the common ground electrode 27A arranged on the substrate 20 may be designed regardless of the areas of these electrodes 23A-23C and 27A. Accordingly, the electrodes 23A-23C and 27A may be suitably arranged to enable mounting of the LEDs 22A-22C at a high density.

As for a method of mounting the LEDs 22A-22C on the substrate 20 according to an embodiment of the present invention, first, the conductive adhesive 21 is applied to the electrodes 23A-23C and 27A having differing areas. In one example, screening may be used to apply the conductive adhesive 21 to the electrodes 23A-23C and 27A.

Then, the LEDs 22A-22C are mounted on the electrodes 23A-23C and 27A having the conductive adhesive 21 applied thereon. It is noted that at this stage, the resin included in the conductive adhesive 21 is not yet hardened and the LEDs 22A-22C are provisionally attached to the electrodes 23A-23C.

Then, the LEDs 22A-22C provisionally attached to the substrate 20 is introduced into a furnace and the conductive adhesive 21 is heated to its corresponding hardening temperature. It is noted that the heating temperature in this case may be lower than that for bonding LEDs using solder 6. Accordingly, the bonding process using conductive adhesive 21 may be performed under a lower temperature environment compared to conventional bonding processes so that the mounting process may be easily performed.

Also, as is described above, even when a heating process is performed on the conductive adhesive 21, surface tension or a thermal expansion force that is large enough to cause movement of the LEDs 22A-22C may not be generated at the conductive adhesive 21 so that occurrence of the Manhattan phenomenon may be prevented. Thus, chip mounting reliability may be improved by using the chip component mounting method according to the present embodiment.

FIG. 10 is a diagram showing a modified example of the above embodiment of the present invention. In the above-described embodiment, the common ground electrode 27A is arranged at a center position, and the plural LEDs 22A-22C are arranged along radial directions with respect to this center position. However, as an alternative embodiment, a common ground electrode 27B that is arranged into a long band extending in a straight line may be used and the plural LEDs 22A-22C may be connected at the sides of this common ground electrode 27B as is shown in FIG. 10.

In this modified example, the common ground electrode 27B is arranged into a long band with a relatively large area. On the other hand, the signal electrodes 23A-23C to be connected to the connection terminals arranged on the opposite side of the connection terminals for connecting to this common ground terminal 27A have smaller areas compared to the common ground electrode 27A. Accordingly, if solder 6 is used as bonding material for bonding the LEDs 22A-22C in the structure according to this modified example, the Manhattan phenomenon is likely to occur for the above-described reasons.

However, by using the conductive adhesive 21 as the bonding material for bonding the LEDs 22A-22C in this modified example, occurrence of the Manhattan phenomenon may be prevented. It is noted that advantageous effects may be obtained in the structure according to the present modified example particularly in the case where resistor chips or condenser chips are used as chip components.

## Claims

1. A chip component mounting structure including a chip component that is surface mounted on a pair of electrodes formed on a substrate, the chip component mounting structure being **characterized in that**:
the electrodes of said pair of electrodes have differing areas; and
the chip component and the electrodes are bonded using a conductive adhesive.

2. The chip mounting structure as claimed in claim 1, wherein
a plurality of the chip components are mounted on the substrate; and
a plurality of connection terminals of the chip components having identical properties are connected to one common electrode that is formed on the substrate.

3. The chip mounting structure as claimed in claim 1, wherein
a plurality of the chip components are mounted on the substrate;
a plurality of connection terminals of the chip components having identical properties are connected to one common electrode that is formed on the substrate; and
the chip components are radially arranged with respect to the common ground electrode.

4. The chip component mounting structure as claimed in claim 1, wherein
the chip component is a light emitting diode and a plurality of the light emitting diodes are mounted on the substrate;
a plurality of connection terminals of the light emitting diodes having identical properties are connected to one common electrode that is formed on the substrate; and
the chip components are radially arranged with respect to the common ground electrode.

5. The chip component mounting structure as claimed in claim 4, wherein
the light emitting diodes are configured to emit light in different colors.

6. The chip component mounting structure as claimed in claim 1, wherein
the conductive adhesive has a surface tension that is smaller than a surface tension of solder.

7. An electronic device comprising the substrate including the chip component mounting structure as claimed in any one of claims 1 through 6.

8. A chip component mounting structure including a chip component that is surface mounted on a pair of electrodes formed on a substrate, the chip component mounting structure being
**characterized in that**:
a plurality of the chip components are mounted on the substrate;
a plurality of connection terminals of the chip components having identical properties are connected to one common electrode that is formed on the substrate using a conductive adhesive; and
the chip components are radially arranged with respect to the common ground electrode.

9. The chip component mounting structure as claimed in claim 8, wherein
the chip components are light emitting diodes that are configured to emit light in different colors.

10. An electronic device comprising the substrate including the chip component mounting structure as claimed in claim 8 or 9.

11. A chip component mounting method for surface mounting a chip component on a pair of electrodes formed on a substrate, the chip component mounting method comprising the steps of:
arranging a conductive adhesive on the pair of electrodes which electrodes have differing areas; and
connecting the chip component to the electrodes with the conductive adhesive.
